**Europäisches Patentamt**

**European Patent Office**

**Office européen des brevets**

(19)

(11) Veröffentlichungsnummer : **0 614 270 A1**

(12) **EUROPÄISCHE PATENTANMELDUNG**

(21) Anmeldenummer : **94810131.6**

(22) Anmeldetag : **02.03.94**

(51) Int. Cl.⁵ : **H03G 3/20**

(30) Priorität : **05.03.93 CH 654/93**

(43) Veröffentlichungstag der Anmeldung :
**07.09.94 Patentblatt 94/36**

(84) Benannte Vertragsstaaten :
**AT BE CH DE DK ES FR GB IT LI NL PT SE**

(71) Anmelder : **ROYALE CONSULTANTS Ltd.**
**Third floor,**
**27-29 Pembroke Street**
**Dublin 2 (IE)**

(72) Erfinder : **Gut, Max B., Dipl.-Ing.**
**Ahornweg 15**
**CH-6353 Weggis (CH)**

(74) Vertreter : **OK pat AG**
**Hinterbergstrasse 36,**
**Postfach 5254**
**CH-6330 Cham (CH)**

(54) **Verfahren und Einrichtung zum Empfang von digitalen Signalen.**

(57) Mit dieser Einrichtung kann bei Empfängern, deren Verstärkungsregelungskriterim ein konstantes Stör/Rauschsignal ist, die Empfindlichkeit unabhängig von empfangenen Nutzsignalen geregelt werden, so dass der Empfang langandauernder Informationsflüsse möglich ist. Zu diesem Zweck ist eine Diode (D1) vorgesehen, die mit der Anode an einer Spannungsquelle angeschlossen ist, und mit der Kathode einerseits mit einer Stromquelle (Q4) und andererseits mit der Kathode einer weiteren Diode (D2) verbunden ist, deren Anode mit dem Kondensator (C12) in Verbindung steht. Ueber dem Kondensator (C12) liegt eine erste Spannung, die im Ruhezustand kleiner ist als eine über die eine Diode (D1) zugeführte zweite Spannung, so dass die weitere Diode (D2) gesperrt ist. Nach Empfang eines Nutzsignals wird in Abhängigkeit von einem Ausgangssignal eines Signaldetektors ein Entladeimpuls (EP) erzeugt, durch welchen die zweite Spannung auf einen Wert erniedrigt wird, der kleiner als die erste Spannung ist. Dabei wird der Kondensator (C12) so weit entladen, dass die abgeflossene Ladung der beim Empfang eines Nutzsignals auf den Kondensator (C12) gebrachten Ladung entspricht.

Fig. 5

EP 0 614 270 A1

Die Erfindung betrifft ein Verfahren und eine Einrichtung für den Empfang von digitalen Signalen in Form von aus Schwingungspaketen bestehenden Impulsen. Beim Verfahren werden die empfangenen Signale nach Filterung und Verstärkung einem Signaldetektor und anschliessend einer Störunterdrückungsschaltung zugeführt, wobei der Signaldetektor nach Empfang eines Signals ein Ausgangssignal erzeugt. Dabei wird zum Zwecke einer automatischen Verstärkungsregelung vorausgesetzt, dass Stör- und Nutzsignale einen Kondensator aufladen, derart, dass bei weniger Signalen, die einen Schwellenpegel überschreiten, und entsprechend kleinerer Ladung die Empfindlichkeit gesteigert und bei mehr Signalen, die einen Schwellenpegel überschreiten, und damit entsprechend grösserer Ladung die Empfindlichkeit wieder reduziert wird.

Mit dem Empfängerbaustein U 2506 B von AEG Telefunken ist eine Einrichtung bekannt geworden, die in monolithisch integrierter Form im Handel erhältlich ist. Die zu empfangenden digitalen Signale sind mittels Pulsburst-Positionsmodulation modulierte Impulse in Form von Schwingungspaketen, die einer Eingangsstufe zugeführt werden. Die Signale werden dann verstärkt und über ein Hochpassfilter geleitet, womit eine starke Unterdrückung von Störsignalen tiefer Frequenz erreicht wird. Nach erneuter Verstärkung werden die Signale einem Tiefpassfilter zugeführt und danach nochmals verstärkt. Die derart maximal verstärkten Signale werden einer Impulszählschaltung zugeführt. Diese besteht im wesentlichen aus drei hintereinandergeschalteten Komparatoren und erzeugt nach Empfang einer minimalen Anzahl Schwingungen einen Impuls. Dieser Impuls wird in eine Impulsformerstufe übertragen, welche daraufhin ein Ausgangssignal konstanter Dauer erzeugt, das das eigentliche Nutzsignal darstellt und dessen zeitliche Position mit dem empfangenen Schwingungspaket korrespondiert.

In einer Störunterdrückungsschaltung und einer Schaltung für die automatische Verstärkungsregelung (AGC) der genannten Einrichtung wird der Empfang durch Reduktion der Verstärkung gegen Störungen unempfindlich gemacht. Hierbei wird in Verbindung mit einer automatischen Verstärkungsregelung bei Empfang von weniger Signalen, die einen Schwellenpegel überschreiten, die Empfindlichkeit gesteigert, wobei jedoch mit zunehmender Empfindlichkeit mehr Störsignale zur Auswirkung kommen, so dass die Empfindlichkeit wieder reduziert werden muss. Auf diese Weise wird der Störpegel am Eingang der Impulszählstufe nahezu konstant gehalten und die Empfindlichkeit optimal eingestellt.

Da das Regelungskriterium bei vorstehend beschriebenem Empfängerbaustein ein konstantes Stör/Rauschsignal ist, können keine grossen Datenmengen während längerer Zeit übermittelt werden. Der Empfängerbaustein interpretiert ein Nutzsignal in gleicher Weise wie ein Störsignal und regelt daher bei empfangenem Nutzsignal seine Empfindlichkeit so stark herab, dass das Nutzsignal das Ausgangssignal nicht mehr sicher erzeugen kann. Da die Impulsformerstufe für jedes empfangene Schwingungspaket und unabhängig von seiner Dauer nur ein Ausgangssignal von konstanter Dauer generiert, kann keine Pulsburst-Breitenmodulation angewendet werden.

Der Erfindung liegt die Aufgabe zugrunde, ein Verfahren der eingangs genannten Art sowie eine Empfangseinrichtung zur Durchführung des Verfahrens vorzuschlagen, die lange Informationsübermittlungen und die Anwendung auch von Pulsburst-Breitenmodulation ermöglichen, wobei dennoch die im Stand der Technik beschriebenen Regelungseigenschaften (insbesondere Regelung auf konstantes Stör/Rauschsignal) bzw. eine gute Störunterdrückung erhalten bleiben.

Diese Aufgabe wird bezüglich des Verfahrens durch die im Patentanspruch 1 gekennzeichnete Erfindung gelöst. Demnach wird nach Empfang eines Nutzsignals in Abhängigkeit vom genannten Ausgangssignal der Impulszählschaltung ein Entladeimpuls erzeugt, bei dessen Auftreten die durch das Nutzsignal auf den Kondensator gebrachte Ladung wieder abgeführt wird. Dabei wird der Kondensator so weit entladen, dass die abgeflossene Ladung der beim Empfang eines Nutzsignals auf den Kondensator gebrachten Ladung entspricht.

Erfindungsgemässe Empfangsschaltungen zur Durchführung des Verfahrens in verschiedenen Varianten sind in den Patentansprüchen 10 bis 13 angegeben.

Die mit der Erfindung erzielten Vorteile sind hauptsächlich darin zu sehen, dass sich die Empfangsverhältnisse jeweils nach Empfang eines Nutzsignals wieder so einstellen, wie sie vor dessen Eintreffen bestanden. Damit kann nach Empfang eines sehr starken Signals unmittelbar ein sehr schwaches Signal empfangen werden. Die globale Empfindlichkeit der Einrichtung wird somit durch das Nutzsignal nicht mehr beeinflusst, sondern nur noch durch Störsignale, und die Einrichtung kann jetzt auch für den Empfang langandauernder sowie mittels Pulsburst-Positions- und/oder Pulsburst-Breitenmodulation modulierter Informationsflüsse eingesetzt werden. Gemäss einer besonderen Ausführungsform ist die Einrichtung unmittelbar nach dem Ende eines Schwingungspaketes für den Empfang des nächsten bereit, so dass sich die Datenübertragungsrate wesentlich erhöhen lässt.

Im folgenden wird die Erfindung anhand verschiedener Ausführungsbeispiele in Verbindung mit der Zeichnung näher erläutert.

Es zeigen:

Fig. 1                    ein Schaltschema der Empfangseinrichtung in einer ersten Ausführungsform,

2

Fig. 2 — ein Schaltschema einer Impulszählschaltung der Einrichtung gemäss Fig. 1,

Fig. 3a bis 3e — Zeitdiagramme für das Zusammenwirken verschiedener Eingangs- und Ausgangssignale der Impulszählschaltung nach Fig. 2,

Fig. 4 — das Schaltschema eines Teiles der Einrichtung gemäss Fig. 1 in einer zweiten Ausführungsform,

Fig. 5 — das Schaltschema eines Teiles der Einrichtung gemäss Fig. 1 in einer dritten Variante,

Fig. 6a bis 6d — Zeitdiagramme für das Zusammenwirken von Eingangs- und Ausgangssignalen der dritten Variante nach Fig. 5,

Fig. 7 — ein Blockschaltbild zweier Kommunikationspartner mit je einer erfindungsgemässen Empfangseinrichtung,

Fig. 8 — das Blockschaltbild einer Steuereinheit eines Kommunikationspartners nach Fig. 7,

Fig. 9 — Diagramme, die die Verteilung von Bits und unbenutzten Zeiträumen eines zu übertragenden Informationsflusses zeigen,

Fig. 10 — ein Impulsdiagramm der zu übermittelnden Impulse in Form von Schwingungspaketen,

Fig. 11 — ein Schaltschema eines Teils der Einrichtung gemäss Fig. 1 in einer weiteren Variante, und

Fig. 12a bis 12c — Zeitdiagramme für das Zusammenwirken von Signalen der weiteren Variante nach Fig. 11.

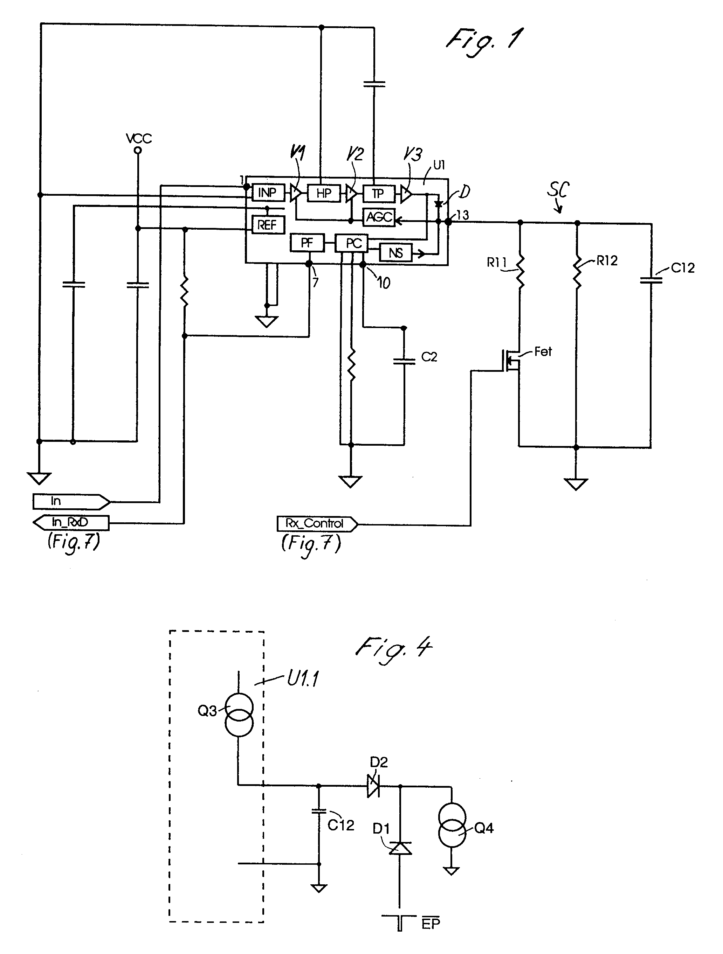

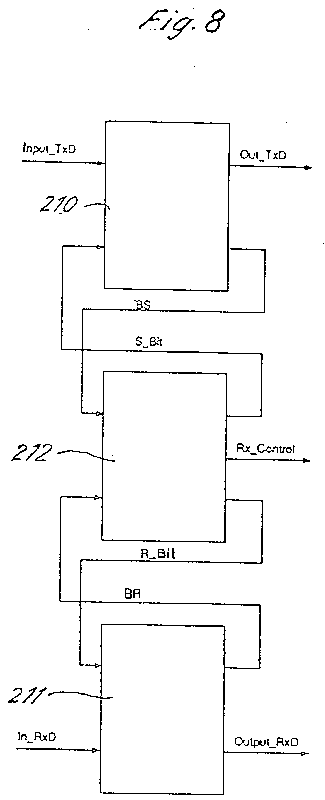

In der Fig. 1 ist mit U1 ein Empfängerbaustein bezeichnet, für welchen vorzugsweise der in monolithisch integrierter Form im Handel erhältliche Baustein U 2506 B von AEG Telefunken verwendet werden kann. Dieser Empfängerbaustein ist insbesondere für den Empfang von Signalen in Form von Schwingungspaketen geeignet, die mittels Pulsburst-Positionsmodulation (PBPM, Fig. 10) moduliert sind, wobei die Schwingungspakete eine Frequenz von z.B. 455 kHz aufweisen. Der Empfängerbaustein U1 enthält im wesentlichen eine Eingangsstufe INP, ein Hochpassfilter HP und ein Tiefpassfilter TP, die über Verstärker V1, V2 in Serie geschaltet sind. Das Tiefpassfilter TP ist mit einem weiteren Verstärker V3 verbunden, dessen Ausgang unmittelbar mit einem Signaldetektor in Form einer Impulszählschaltung PC und über eine Diode D mit einem Anschluss 13 des Bausteins U1 in Verbindung steht. Die Impulszählschaltung PC ist mit einer Impulsformerstufe PF und einer Störunterdrückungsschaltung NS verbunden, deren Ausgang am Anschluss 13 angeschlossen ist. Eine automatische Verstärkungsregelung AGC ist eingangsseitig mit dem Anschluss 13 und ausgangsseitig mit den Verstärkern V1 und V2 verbunden. Ein mit der Impulszählschaltung PC über einen Anschluss 10 verbundener Kondensator C2 gehört funktionell zu dieser Schaltung, ist aber ausserhalb des Empfängerbausteins U1 angeordnet (siehe auch C2, Fig. 2). Mit 1 ist ein Eingang bezeichnet, über welchen die (beispielsweise bei Informationsübertragung mittels Infrarotlicht von einer Photodiode empfangenen) Schwingungspakete der Eingangsstufe INP zugeführt werden. Ueber einen Ausgang 7 wird ein Ausgangssignal der Impulsformerstufe PF abgeführt, welches das eigentliche Nutzsignal darstellt.

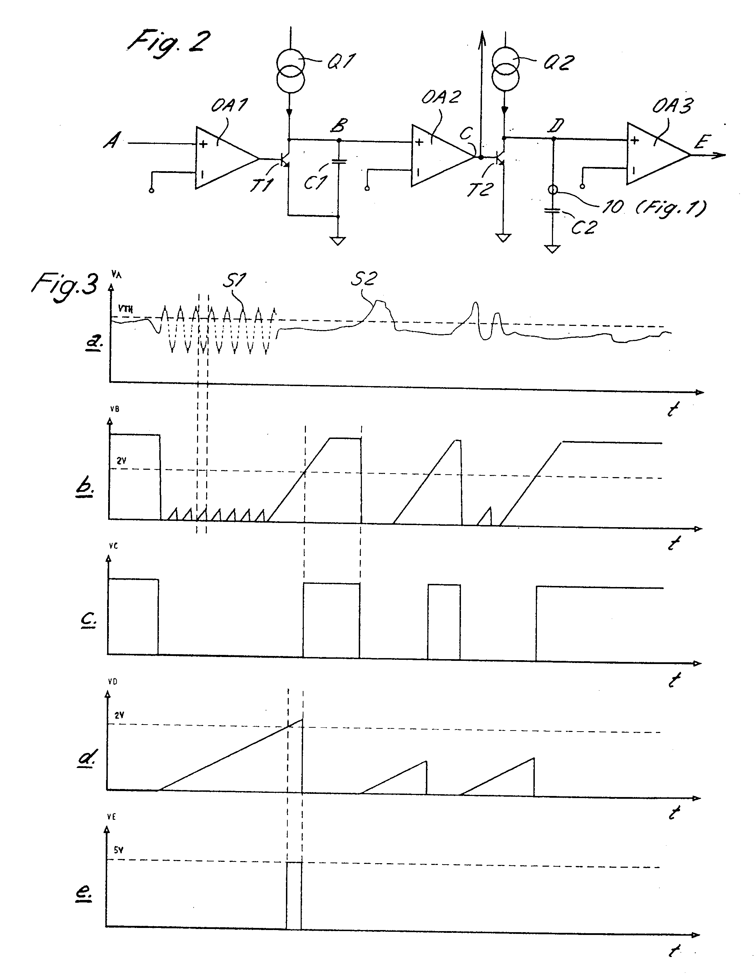

Die automatische Verstärkungsregelung AGC ist über den Anschluss 13 mit einer Schaltungsanordnung SC verbunden, die aus drei parallel geschalteten Zweigen besteht. Hierbei ist im ersten Zweig ein Kondensator C12, im zweiten Zweig ein Widerstand R12 und im dritten Zweig die Serieschaltung eines Widerstandes R11 und eines Feldeffekttransistors Fet angeordnet, dessen Steuerelektrode mit einer Steuereinheit (21, Fig. 7) verbunden ist.

Die nicht gekennzeichneten Verbindungen bzw. Elemente in Fig. 1 dienen im wesentlichen der Stromversorgung, zu welchem Zweck über einen Anschluss VCC eine (nicht dargestellte) Spannungsquelle angeschlossen ist. Weitere, ebenfalls nicht gekennzeichnete Elemente sind für die Funktionsbeschreibung nicht relevant.

Gemäss Fig.2 besteht die Impulszählschaltung PC aus drei hintereinander geschalteten Komparatoren OA1, OA2, OA3, wobei der Ausgang der ersten beiden Komparatoren OA1, OA2 jeweils an der Basis eines Transistors T1 bzw. T2 angeschlossen ist, deren Kollektor mit dem einen Eingang des nachfolgenden Komparators OA2 bzw. OA3 und mit einer Konstantstromquelle Q1 bzw. Q2 verbunden ist. In den Ausgangskreisen der Transistoren T1, T2 sind Kondensatoren C1, C2 vorgesehen, wobei der Kondensator C2, wie erwähnt, ausserhalb der Impulszählschaltung PC angeordnet ist (siehe auch Fig. 1). Der Ausgang C des zweiten Komparators OA2 ist mit der Störunterdrückungsschaltung NS und der Ausgang E des dritten Komparators OA3 mit der Impulsformerstufe PF verbunden. Dem einen Eingang A des ersten Komparators OA1 werden die gefilterten und verstärkten Schwingungspakete vom Verstärker V3 (Fig. 1) zugeführt, während an den anderen Eingängen aller drei Komparatoren OA1, OA2, OA3 konstante Schwellen- bzw. Referenzspannungen angelegt sind.

Im Diagramm Fig.3a ist mit S1 ein Nutzsignal und mit S2 ein Störsignal bezeichnet, wobei das Nutzsignal S1 bei Anwendung der Pulsburst-Positionsmodulation in Form von Schwingungspaketen konstanter Dauer empfangen wird. Nutz- und Störsignal S1, S2 treten als Spannung VA am Eingang A des ersten Komparators OA1 auf und werden mit einer Schwellenspannung VTH von beispielsweise 20 mV verglichen.

Fig.3b und 3c zeigen die Spannungsverläufe VB bzw. VC an dem einen Eingang und am Ausgang des zweiten Komparators OA2 (Punkt B und Ausgang C), wobei die Referenzspannung beispielsweise 2V beträgt.

Fig.3d zeigt den Spannungsverlauf VD an dem einen Eingang des dritten Komparators OA3 (Punkt D).

In Fig.3e ist ein (bei einer Referenzspannung von 2V nach Fig. 3d) am Ausgang E des dritten Komparators OA3 auftretendes Ausgangssignal in Form eines Triggerimpulses mit einer Spannung VE von 5V dargestellt.

Der an sich bekannte Teil der vorstehend beschriebenen Einrichtung arbeitet wie folgt:

Das der Eingangsstufe INP zugeführte Schwingungspaket wird im Verstärker V1 verstärkt und über das Hochpassfilter HP (Butterworthfilter 5.Ordnung, Eckfrequenz 320 kHz) geleitet. Damit wird eine starke Unterdrückung von Störsignalen tieferer Frequenzen erreicht. Nach einer weiteren Verstärkung im Verstärker V2 wird das Nutzsignal S1 zwecks zusätzlicher Verbesserung der Uebertragungseigenschaften über das Tiefpassfilter TP (Butterworthfilter 3. Ordnung, Eckfrequenz 500 kHz) geführt und im weiteren Verstärker V3 nochmals verstärkt, wobei eine maximale Verstärkung von 90 dB erreicht wird. Das so verstärkte Nutzsignal S1 wird dem Eingang A der Impulszählschaltung PC zugeführt, wobei der erste Komparator OA1 beim Ueberschreiten der Schwellenspannung VTH von 20 mV ein Steuersignal erzeugt, mit dem der Transistor T1 angesteuert wird (Fig.2, 3a). Hierbei wird der seine Ladung von der ersten Konstantstromquelle QI erhaltende erste Kondensator CI immer dann entladen, wenn das Nutz- oder Störsignal S1, S2 jeweils die Schwellenspannung VTH überschreitet, wobei sich am Punkt B (Fig. 2) der Spannungsverlauf VB gemäss Fig. 3b ergibt. Mit der Referenzspannung von 2V verglichen, ergibt sich am Ausgang C des zweiten Komparators OA2 der Spannungsverlauf VC gemäss Fig. 3c, mittels welchem der Transistor T2 angesteuert wird. Dabei wird der seine Ladung von der zweiten Konstantstromquelle Q2 erhaltende Kondensator C2 immer dann entladen, wenn die Spannung am Punkt B die Referenzspannung von 2V überschreitet (Fig. 2). Beim Unterschreiten der Referenzspannung wird der Kondensator C2 wieder aufgeladen, wobei sich am Punkt D der Spannungsverlauf VD gemäss Fig. 3d ergibt. Die Verhältnisse sind nun so gewählt, dass die mit konstanter Steigung ansteigende Spannung VD die Referenzspannung von 2V des dritten Komparators OA3 nach einer Zeit von ca. 18 $\mu$s erreicht, was acht Schwingungen eines Schwingungspaketes bei einer Frequenz von 455 kHz entspricht. Bei Ueberschreiten der Referenzspannung erscheint am Ausgang E des dritten Komparators OA3 das erste Ausgangssignal in Form eines Triggerimpulses (Fig. 3e), mittels welchem die nachfolgende Impulsformerstufe PF (Fig. 1) ein Ausgangssignal von bestimmter, konstanter Dauer erzeugt, welches das eigentliche Nutzsignal darstellt.

In der Störunterdrückungsschaltung NS erfolgt eine Herabsetzung der Empfindlichkeit bzw. der Empfängerverstärkung zwecks Erzielung eines grossen Störabstandes: Während der Dauer jedes negativen Impulses am Punkt C (Fig. 2, 3c) wird der Kondensator C12 der Schaltungsanordnung SC (Fig. 1) mit einem konstanten Strom von ca. 10 $\mu$A geladen. Werden nun nur wenige Impulse empfangen, so ist der Mittelwert dieses Ladestromes kleiner als ein interner Entladestrom, welcher die Abklingzeit (decay time) der automatischen Verstärkungsregelung AGC repräsentiert. Ist der Kondensator C12 auf einen bestimmten Wert geladen und hat die Einrichtung seit kurzem kein Signal mehr empfangen, so steigert sich die Empfindlichkeit. Mit zunehmender Empfindlichkeit überschreiten aber anderseits mehr Störsignale am Eingang A, Fig. 2 die Schwellenspannung VTH des Komparators OA1. Diese Signale laden damit in vermehrter Häufigkeit den Kondensator C12, was die Empfindlichkeit wieder reduziert. Damit wird der Störpegel im Punkt A aufgrund eines dynamischen Gleichgewichtes zwischen Aufladung und Entladung des Kondensators C12 auf nahezu konstantem Pegel gehalten und die Empfindlichkeit optimal eingestellt. Die Schaltung interpretiert jedoch das Nutzsignal in gleicher Weise wie ein Störsignal und regelt somit bei empfangenem, länger andauerndem Nutzsignal (bzw. bei einer längeren Impulsfolge) ihre Empfindlichkeit so stark herab, dass das Nutzsignal die Ausgangssignale (Triggerimpulse nach Fig. 3e) nicht mehr sicher erzeugen kann. Müssen langandauernde Informationsflüsse übermittelt werden, so muss also ein anderes Regelungskriterium verwendet werden, wie nachstehend näher beschrieben wird.

In der Fig.4 ist mit U1.1 ein Teil einer Ersatzschaltung des Empfängerbausteines U1 (Fig.1) bezeichnet. Eine Stromquelle Q3 der Ersatzschaltung ist mit einem Kondensator C12 verbunden, welcher dem Kondensator C12 nach Fig.1 entspricht. Mit D1 ist eine erste Diode bezeichnet, die mit ihrer Kathode einerseits mit einer weiteren Stromquelle Q4 und andererseits mit der Kathode einer weiteren Diode D2 verbunden ist, deren Anode mit dem Kondensator C12 in Verbindung steht. Mit $\overline{EP}$ ist ein Entladeimpuls bezeichnet, der von einer nicht weiter dargestellten Monoflop-Stufe mit Spannungsquellen-Charakteristik erzeugt und an die Anode der Diode D1 gelegt wird.

Die vorstehend beschriebene Schaltungsanordnung gemäss Fig.4 arbeitet wie folgt:

Im Ruhezustand ist eine erste Spannung am Kondensator C12 kleiner als eine zweite, über die Diode D1 zugeführte Spannung, so dass die zweite Diode D2 gesperrt ist und die weitere Stromquelle Q4 über die Diode D1 aus deren Spannungsquelle gespeist wird. Am Ende des von der Impulsformerstufe PF erzeugten Ausgangssignals konstanter Dauer wird dessen Endflanke als Triggersignal für das erwähnte Monoflop benutzt, welches daraufhin den Entladeimpuls $\overline{EP}$ erzeugt. Bei Auftreten des Entladeimpulses $\overline{EP}$ wird die zweite Spannung auf einen Wert vermindert, der kleiner als die erste Spannung ist, so dass die weitere Diode D2 leitend und die Diode D1 gesperrt wird, wobei der Kondensator C12 sich entlädt und der Entladestrom über die weitere Stromquelle Q4 fliesst. Hierbei ist die vom Kondensator C12 abfliessende Ladung dem Produkt aus dem Entladestrom und der Dauer des Entladeimpulses $\overline{EP}$ proportional und entspricht der durch das Nutzsignal vorher auf den Kondensator C12 aufgebrachten Ladung. Auf diese Weise wird erreicht, dass die durch das Nutzsignal aufgebrachte und durch den Entladeimpuls $\overline{EP}$ weggeführte Ladung auf dem Kondensator C12 im zeitlichen Durchschnitt Null ist, so dass die Regelungseigenschaften des Empfängerbausteines wie bisher erhalten bleiben und dennoch lange Informationen (lange Impulsfolgen) übermittelt werden können. - Anstelle der Dioden-Kombination D1, D2 in Fig. 4 könnte selbstverständlich auch ein Schalttransistor eingesetzt werden.

Die vorstehend beschriebene Schaltungsanordnung nach Fig.4 kann approximativ auch durch den Schaltungsteil SC nach Fig.1 realisiert werden. Der Entladeimpuls - hier mit "Rx_Control" bezeichnet - wird hierbei von einer Steuereinheit 21 (Fig.7) erzeugt und auf den Feldeffekttransistor Fet geleitet. Bei Auftreten des Entladeimpulses am Feldeffekttransistor Fet wird dieser leitend und der Gesamtwiderstand im dritten Zweig verkleinert, so dass über die Serieschaltung aus R11 und Fet eine dem Nutzsignal entsprechende Ladung vom Kondensator C12 abfliessen kann.

Bei Anwendung der Pulsburst-Breitenmodulation, bei welcher Schwingungspakete von mindestens zwei verschiedenen Dauern verarbeitet werden, muss auch die unterschiedliche Ladung, die durch die unterschiedliche Signallänge verursacht wird, korrekt kompensiert werden. Da hierbei die Impulsformerstufe PF nicht mehr verwendet werden kann, muss eine nachstehend anhand der Fig. 5 und 6 beschriebene Schaltungsanordnung angewendet werden.

Gemäss Fig.5 weist ein Teil U1.2 einer Ersatzschaltung des Empfängerbausteins U1 (Fig.1) einen Komparator OA3' und eine Stromquelle Q3' auf. Der Komparator OA3' ist ausserhalb des Empfängerbausteins angeordnet und mit einem Eingang am Kondensator C2 (Fig. 1) angeschlossen, der identisch mit dem Kondensator C2 in Fig. 2 ist. Die Stromquelle Q3' ist mit einem Kondensator C12 verbunden, welcher dem Kondensator C12 in der Fig. 1 entspricht. Mit D1' ist eine Diode bezeichnet, deren Anode an einem Ausgang $\overline{a}$ eines Monoflops MF angeschlossen ist. Die Kathode der Diode D1' ist einerseits mit einer spannungsgesteuerten Stromquelle Q5 und andererseits mit der Kathode einer weiteren Diode D2' verbunden, deren Anode mit dem Kondensator C12 in Verbindung steht. Im Ausgangskreis eines Transistors T1' ist ein Integrationskondensator Ci angeordnet, der zusammen mit dem Kollektor des Transistors T1' mit einer Konstantstromquelle Q6 und der spannungsgesteuerten Stromquelle Q5 verbunden ist. Die Basis des Transistors T1' ist am Ausgang eines zwei Eingänge aufweisenden NOR-Gatters NOR angeschlossen, dessen einer Eingang mit dem Ausgang E' des Komparators OA3' und dem Eingang e des Monoflops MF verbunden ist. Der andere Eingang des NOR-Gatters ist an einem weiteren Ausgang a des Monoflops MF angeschlossen. Mit EP ist ein am Ausgang a auftretender positiver Impuls und mit $\overline{EP}$ ein am Ausgang $\overline{a}$ auftretender negativer Entladeimpuls bezeichnet. Ein am Ausgang E' des Komparators OA3' erscheinendes Ausgangssignal ist mit AS bezeichnet und stellt das nun pulsbreitenmodulierte Nutzsignal dar.

In der Fig.6 zeigen:
a das empfangene Nutzsignal in Form eines mittels Pulsburst-Breitenmodulation modulierten Schwingungspaketes (Fig.10);
b den Spannungsverlauf des Kondensators C2 der Impulszählschaltung PC (Fig.2, Punkt D);
c das Ausgangssignal AS am Ausgang E' des Komparators OA3' (Fig. 5);
d den Entladeimpuls $\overline{EP}$ am Ausgang $\overline{a}$ des Monoflops MF (Fig. 5).

Die vorstehend beschriebene Schaltungsanordnung gemäss Fig. 5 arbeitet wie folgt:

Nach den ersten acht Schwingungen des empfangenen Schwingungspaketes schaltet der Komparator OA3' (Punkt P, Fig. 6b), wobei an seinem Ausgang E' das Ausgangssignal AS erscheint (Fig. 6c). Bei Auftreten des Ausgangssignals AS wird der Transistor T1' gesperrt, so dass der Integrationskondensator Ci von der Konstantstromquelle Q6 linear aufgeladen wird. Die Spannung über dem Integrationskondensator Ci ist ein Mass für die Impulsdauer und wird der spannungsgesteuerten Stromquelle Q5 zugeführt, wobei ein entsprechender Strom Ie von der Stromquelle Q5 durch die Diode Dl' fliesst und an der Kathode der weiteren Diode D2' eine Spannung liegt, die grösser als die über dem Kondensator C12 liegende ist, so dass die weitere Diode D2' sperrt. Bei Erscheinen der Endflanke des ersten Ausgangssignals AS am Ende des Schwingungspaketes schaltet das Monoflop MF, wobei am Ausgang a der positive Impuls EP und am Ausgang $\overline{a}$ der negative Entladeimpuls $\overline{EP}$ auftritt (Fig. 6d).

Unter Vernachlässigung der Laufzeit im Monoflop MF bleibt hierbei der Transistor T1' nach wie vor gesperrt und die Konstantstromquelle Q6 lädt weiterhin den Integrationskondensator Ci auf. Mit dem Auftreten des positiven Impulses EP wird jedoch der Strom durch die spannungsgesteuerte Stromquelle Q5 um einen weiteren Betrag $\Delta$le verändert. Durch den Entladeimpuls $\overline{EP}$ sinkt die anodenseitige Spannung an der Diode D1' ab, womit sie sperrt und die weitere Diode D2' leitend wird und die Entladung des Kondensators C12 eingeleitet wird.

Bei der Entladung des Kondensators C12 werden folgende Teilladungen entfernt:

a) Ladung, die durch die ersten acht Schwingungen des Nutzsignals auf den Kondensator gebracht wird. Sie entspricht dem empfangenen Nutzsignal, bis das Ausgangssignal AS das Vorhandensein des Nutzsignals meldet, vermindert um den Betrag des Produktes von $\Delta$le und der Dauer des Entladeimpulses $\overline{EP}$ (konstante Ladung);

b) Ladung, die das Nutzsignal auf den Kondensator bringt, während das Ausgangssignal AS das Vorhandensein des Nutzsignals meldet (variabler Anteil der Ladung, verursacht durch die unterschiedliche Signaldauer bei Impulsbreite-Modulation).

Da die vorstehend beschriebene Empfangsschaltung nach Empfang von Signalen mit sehr hohen Eingangssignalstärken sofort wieder für den Empfang auch sehr schwacher Signale bereit ist, kann sie mit Vorteil für ein Verfahren zur bidirektionalen Informationsübertragung verwendet werden, also zwischen Kommunikationspartnern, die je Sender und Empfänger aufweisen; ein solches Verfahren wird nachfolgend anhand der Fig. 7, 8 und 9 kurz beschrieben. Bei diesem Verfahren wird jeweils ein Bit vom "eigenen" Sender ausgestrahlt (ergibt eine sehr hohe Eingangssignalstärke beim betreffenden Empfänger) und anschliessend unmittelbar ein Bit des Senders eines anderen, entfernten Kommunikationspartners empfangen (schwache Signalstärke).

In der Fig.7 sind mit KP1 und KP2 zwei Kommunikationspartner, wie beispielsweise Computer oder andere intelligente elektronische Systeme bezeichnet. Jeder Kommunikationspartner KP1, KP2 weist eine Steuereinheit 21, einen Sender 22 und einen Empfänger 23 auf, wobei die Steuereinheit 21 über eine Leitung Out_TxD mit dem Sender 22 und über Leitungen In_RxD und Rx_Control mit dem Empfänger 23 verbunden ist. An der Steuereinheit 21 ist ein Oszillator 24 angeschlossen, der ein Taktsignal mit einer Frequenz von beispielsweise 5,0688 MHz erzeugt. Ueber Leitungen Input_TxD und Output_RxD steht die Steuereinheit 21 mit einem Spannungspegelwandler 25 in Verbindung, dem über die Leitung TxD die zu sendenden Informationen zugeführt werden und der über die Leitung RxD die empfangenen Informationen abgibt. Mit gestrichelten Pfeilen IR-Tx, IR-Rx sind die beispielsweise mittels Lichtwellen oder Funk zu übertragenden, gesendeten bzw. empfangenen Informationen symbolisiert. Mit Flow_bridge, Test und Loop_ back sind drei Eingänge der Steuereinheit 21 bezeichnet, über welche entsprechende Betriebsarten aktiviert werden können.

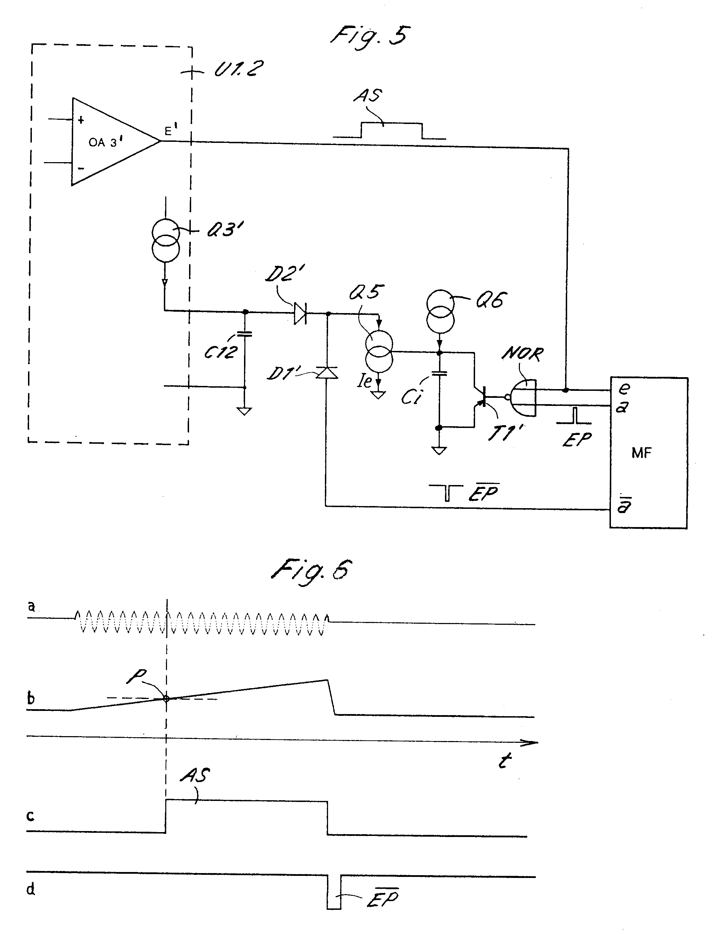

Nach Fig.8 besteht die Steuereinheit 21 aus einem Sendeteil 210, einem Empfangsteil 211 und einem Schaltwerk 212 (state machine). Die Teile 210, 211 und das Schaltwerk 212 sind über Leitungen BS, S_Bit und BR, R_Bit miteinander verbunden, über welche "Handshaking"-Signale ausgetauscht werden, wobei Sendeteil 210 und Empfangsteil 211 sendebezogene bzw. empfangsbezogene Aufgaben erfüllen und das Schaltwerk 212 die Funktion beider Teile 210, 211 koordiniert sowie Signale Rx_control erzeugt, die für die Steuerung des Empfängers 23 notwendig sind (s. auch Fig. 1).

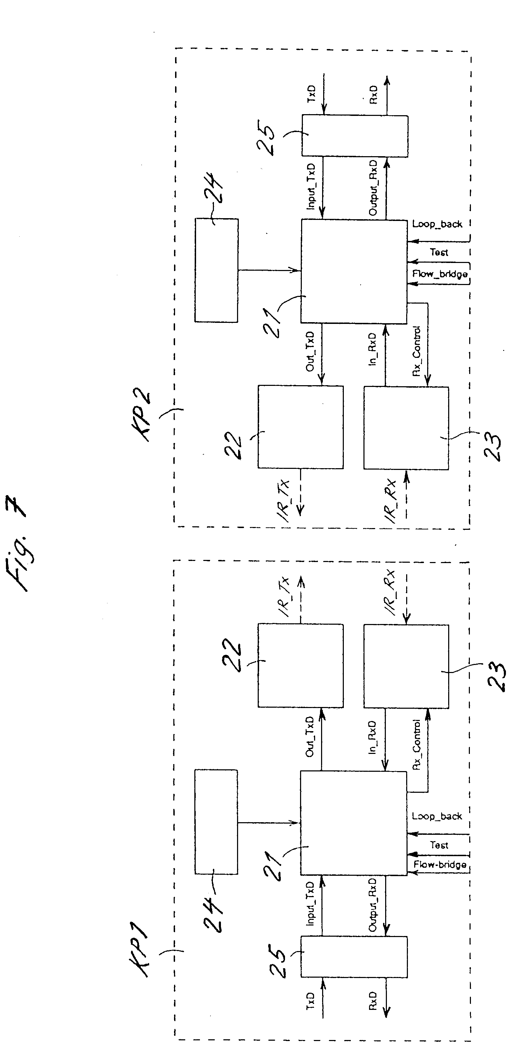

Gemäss Fig.9 ist der zeitliche Abstand ta zwischen den Anfängen der aufeinanderfolgenden Bits eines Informationsflusses in zwei zeitlich gleiche Hälften tb, tc geteilt. Die Bits sind verkürzt und werden nur während der ersten Hälfte tb übertragen, wobei die zweiten Hälften tc für den betreffenden Informationsfluss unbenutzte Zeiträume darstellen. Dadurch wird es möglich, dass zwei Kommunikationspartner gleichzeitig, also bidirektional Informationen austauschen können, da die gesendeten Bits des einen Informationsflusses jeweils in den zweiten Hälften tc des entgegengesetzt gerichteten Informationsflusses übertragen werden. In der nachfolgenden Beschreibung wird für den zeitlichen Abstand ta auch die Bezeichnung "Signalelement" verwendet.

In der Fig.10 zeigen:

PBPM    Mittels Pulsburst-Positionsmodulation modulierte Impulse (Bits) konstanter Dauer in Form von Schwingungspaketen. Hierbei beginnt ein Schwingungspaket für die Kennzeichnung von logisch "1" unmittelbar am Anfang des zeitlichen Abstandes ta, und eines für die Kennzeichnung von logisch "O" nach einer bestimmten Verzögerungszeit nach dem Anfang des zeitlichen Abstandes ta.

PBBM    Mittels Pulsburst-Breitenmodulation modulierte Impulse (Bits) verschiedener Dauer in Form von Schwingungspaketen. Hierbei wird für die Kennzeichnung von logisch "1" ein Schwingungspaket langer Dauer, und für die Kennzeichnung von logisch "O" eines von kurzer Dauer verwendet.

In Kommunikationsnetzwerken mit mehreren Teilnehmern, bei denen für die Durchführung eines geordneten Informationsaustausches beispielsweise ein CSMA/CA-Protokoll (carrier sense, multiple access/collision avoidance) angewendet wird, kann eine Kombination beider Modulationsarten PBPM und PBBM benutzt werden. Hierbei kennzeichnet sich ein Kommunikationspartner, der Uebermittlungsbedarf hat und noch kein Bit empfangen hat, als initiierender Kommunikationspartner IKP und einer, der keinen Uebermittlungsbedarf hat, jedoch ein Bit empfangen hat, als empfangender Kommunikationspartner EKP. Zu Beginn der Informationsübertragung sendet der initiierende Kommunikationspartner IKP ein seine Kennzeichnung ausdrückendes Startbit doppelter Länge (PBBM, logisch "1", Fig.10) und wartet dann eine bestimmte Zeit, während welcher der empfangende Kommunikationspartner EKP ein Echo in Form eines Startbits einfacher Länge (PBPM, logisch "I", Fig.10) zurücksendet (Loop_back-Betrieb). Der initiierende Kommunikationspartner IKP wartet nach jedem gesendeten Bit auf das Echo und vergleicht es bei Eintreffen mit dem gesendeten Bit (Test), wobei er bei Ungleichheit seine Sendung abbricht.

Ein anderer empfangender Kommunikationspartner EKP, der das zurückgesendete Startbit einfacher Länge empfängt, wird nicht seinerseits ein Echo zurücksenden. Ob es sich um ein Startbit einfacher oder doppelter Länge handelt, kann in Abhängigkeit von der Ladung des Kondensators C2 (Fig. 1, 2, 6b) während der halben Signalelementdauer tb vom empfangenden Kommunikationspartner EKP überprüft werden.

Es ist offensichtlich, dass bei den behandelten Einrichtungen auch die zu ihnen dualen Schaltungen, die durch die Substitution der verwendeten Elemente durch ihre dualen (z.B. Induktivität-Kapazität, Spannungsquelle-Stromquelle, etc.) entstehen, die gleichen Ergebnisse liefern. Ebenso offensichtlich ist, dass dieses Verfahren für alle Empfänger verwendet werden kann, deren Verstärkungsregelungs-Kriterium das Erreichen eines konstanten Stör/Rauschsignals ist. Schliesslich ist zu betonen, dass als Signaldektor nicht notwendigerweise eine (im bekannten, als Beispiel genannten Empfängerbaustein vorhandene) Impulszählschaltung nach Fig. 2 verwendet werden muss, sondern auch andere an sich bekannte Signaldetektoren für diesen Zweck anwendbar sind.

Es ist auch eine Verfahrensvariante möglich, bei der die durch den Entladeimpuls $\overline{EP}$ vom Kondensator C12 zu entfernende Ladung von einer digitalen Schaltung aufgrund der Signaldauer und dem Erkennen des Signales als Nutzsignal bestimmt wird.

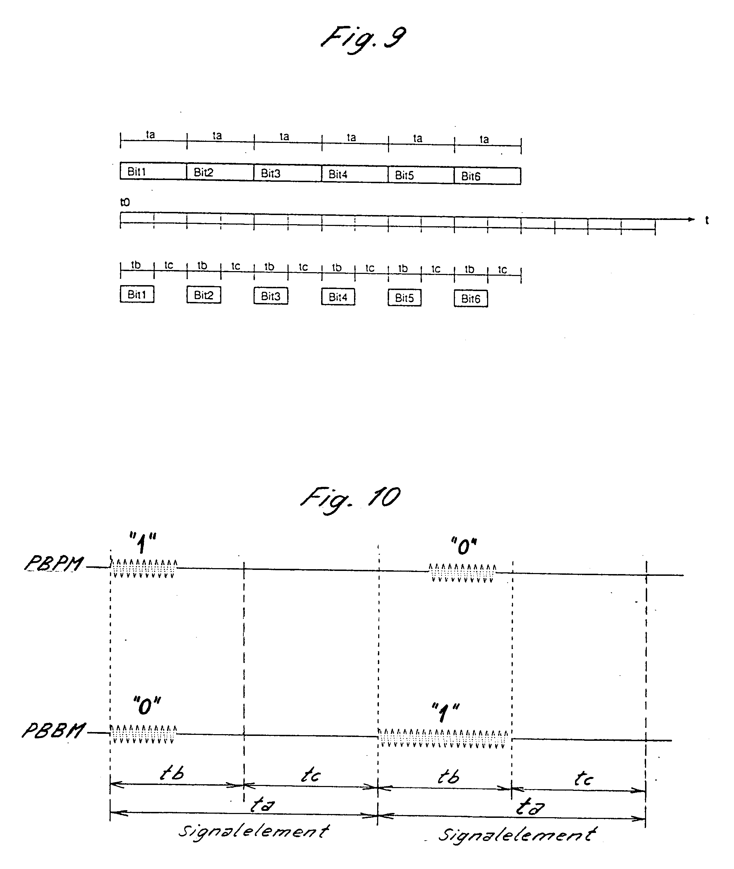

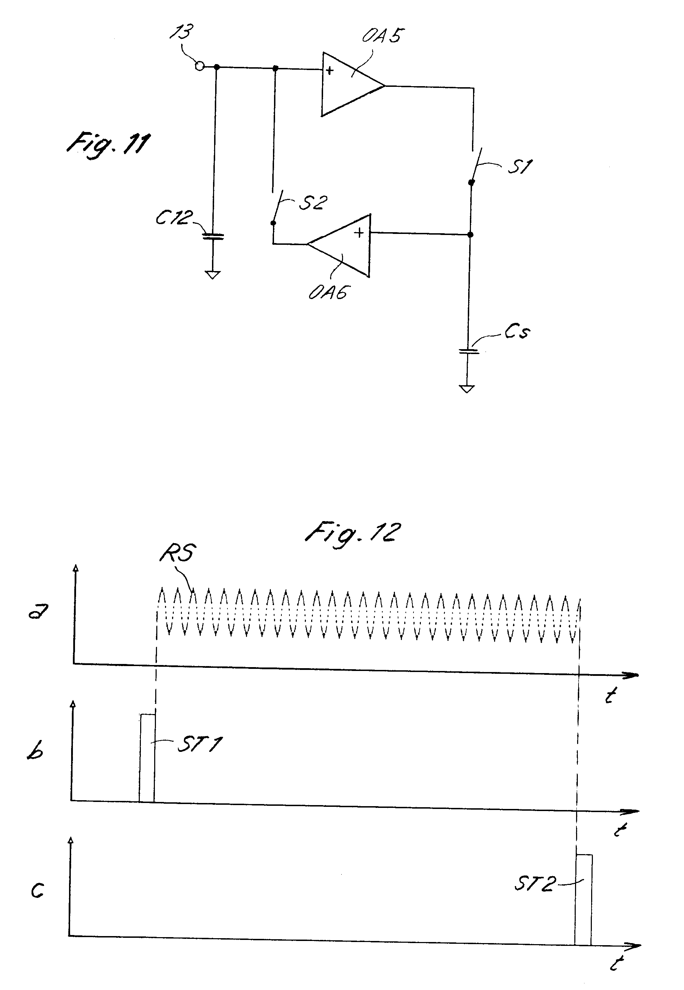

Um, wie anhand der Fig. 4 beschrieben, zu erreichen, dass die durch das Nutzsignal aufgebrachte und dann wieder weggeführte Ladung auf dem Kondensator C12 im zeitlichen Durchschnitt Null ist, kann alternativ - wenn bekannt ist, wann ein Schwingungspaket erscheint - ein nachstehend anhand der Fig. 11 und 12 beschriebenes Verfahren angewendet werden.

In der Fig. 11 sind mit OA5 und OA6 zwei Operationsverstärker bezeichnet. Der Ausgang des ersten Operationsverstärkers OA5 ist über einen ersten Schalter S1 mit einem Eingang des zweiten Operationsverstärker OA6 verbunden, dessen Ausgang über einen zweiten Schalter S2 an einem Eingang des ersten Operationsverstärkers OA5 angeschlossen ist. Dieser Eingang steht weiterhin mit einem Anschluss 13 und einem Kondensator C12 in Verbindung, die dem Anschluss 13 und dem Kondensator C12 der Fig. 1 entsprechen. Der eine Eingang des zweiten Operationsverstärkers OA6 ist mit einem weiteren Kondensator Cs verbunden.

In der Fig. 12 zeigen:

a das empfangene Nutzsignal RS in Form eines Schwingungspaketes,

b einen Steuerimpuls ST1 für den ersten Schalter S1, und

c einen Steuerimpuls ST2 für den zweiten Schalter S2.

Die vorstehend anhand der Fig. 11 und 12 beschriebene Einrichtung arbeitet wie folgt:

Vor Erscheinen des Nutzsignals RS (in einem voraus bekannten Zeitpunkt) wird der Steuerimpuls ST1 erzeugt, so dass der erste Schalter S1 geschlossen und die Spannung am Kondensator C12 über den ersten Operationsverstärker OA5 auf den Kondensator Cs übertragen wird. Nach dem Oeffnen des Schalters S1 wird die so übertragene Spannung am Kondensator Cs gehalten. Am Ende des Nutzsignals RS wird der Steuerimpuls ST2 erzeugt, so dass der zweite Schalter S2 geschlossen und die Spannung am Kondensator Cs über den zweiten Operationsverstärker OA6 auf den Kondensator C12 zurück übertragen wird. Auf diese Weise wird die Spannung am Kondensator C12 wieder auf das gleiche Niveau gezwungen, wie es vor Erscheinen des Nutzsignals RS war. Voraussetzung dabei ist, dass die Gesamtverstärkung der beiden Operationsverstärker OA5 und OA6 gleich 1 ist.

## Patentansprüche

1. Verfahren zum Empfang von digitalen Signalen in Form von aus Schwingungspaketen bestehenden Impulsen, wobei die empfangenen Signale nach Filterung und Verstärkung einem Signaldetektor (PC) und anschliessend einer Störunterdrückungsschaltung (NS) zugeführt werden, und wobei der Signaldetektor (PC) nach Empfang eines Signals ein Ausgangssignal erzeugt, und wobei zum Zwecke einer automatischen Verstärkungsregelung während des Auftretens von Stör- und Nutzsignalen ein Kondensator (C12) aufgeladen wird, derart, dass bei weniger Signalen, die einen Schwellenpegel überschreiten, und entsprechend kleinerer Ladung die Empfindlichkeit gesteigert und bei mehr Signalen, die einen Schwellenpegel überschreiten, und entsprechend grösserer Ladung die Empfindlichkeit wieder reduziert wird, dadurch **gekennzeichnet**,

dass in Abhängigkeit vom genannten Ausgangssignal des Signaldetektors (PC) ein Entladeimpuls ($\overline{EP}$) erzeugt wird, bei dessen Auftreten die durch das Nutzsignal auf den Kondensator (C12) gebrachte Ladung wieder abgeführt wird.

2. Verfahren zum Empfang von Signalen in Form von aus Schwingungspaketen bestehenden Impulsen, wobei die empfangenen Signale nach Filterung und Verstärkung einem Signaldetektor (PC) und anschliessend einer Störunterdrückungsschaltung (NS) zugeführt werden, und wobei der Signaldetektor (PC) nach Empfang eines Signals ein Ausgangssignal erzeugt, und wobei zum Zwecke einer automatischen Verstärkungsregelung während des Auftretens von Stör- und Nutzsignalen ein Kondensator (C12) aufgeladen wird, derart, dass bei weniger Signalen, die einen Schwellenpegel überschreiten, und entsprechend kleinerer Ladung die Empfindlichkeit gesteigert und bei mehr Signalen, die einen Schwellenpegel überschreiten und entsprechend grösserer Ladung die Empfindlichkeit wieder reduziert wird,
dadurch **gekennzeichnet**,
dass vor Erscheinen eines Schwingungspaketes (RS), das ein Nutzsignal darstellt, die Spannung über dem Kondensator (C12) gemessen wird und am Ende dieses Schwingungspaketes die Spannung über dem Kondensator (C12) wieder auf das gleiche Niveau gezwungen wird, wie es vor dem Erscheinen des Schwingunspaketes (RS) war.

3. Verfahren nach Anspruch 1, wobei Schwingungspakete konstanter Dauer empfangen werden und das vom Signaldetektor (PC) erzeugte Ausgangssignal jeweils am Ende eines Schwingungspaketes erscheint und ein Triggerimpuls ist, der einer Impulsformerstufe (PF) zugeführt wird, die daraufhin ein Ausgangssignal konstanter Dauer abgibt, dadurch gekennzeichnet, dass die Endflanke des Ausgangssignals konstanter Dauer als Triggersignal für die Erzeugung des Entladeimpulses ($\overline{EP}$) verwendet wird.

4. Verfahren nach Anspruch 1, wobei Schwingungspakete konstanter Dauer empfangen werden und das vom Signaldetektor in Form einer Impulszählschaltung (PC) erzeugte Ausgangssignal jeweils erst nach dem Empfang einer konstanten Anzahl Schwingungen erscheint und ein Triggerimpuls ist, der einer Impulsformerstufe (PF) zugeführt wird, die daraufhin ein Ausgangssignal konstanter Dauer abgibt, dadurch gekennzeichnet, dass die Endflanke des von der Impulsformerstufe (PF) abgegebenen Ausgangssignals konstanter Dauer als Triggersignal für die Erzeugung des Entladeimpulses ($\overline{EP}$) verwendet wird.

5. Verfahren nach den Ansprüchen 3 oder 4, dadurch gekennzeichnet,
   - dass die Spannung am Kondensator (C12) an die Anode einer Diode (D2) gelegt wird,
   - dass im Ruhezustand eine grössere Spannung an der Kathode der Diode (D2) liegt, so dass der Kondensator (C12) nicht entladen werden kann, und
   - dass bei Erscheinen des Entladeimpulses ($\overline{EP}$) die Spannung an der Kathode der Diode (D2) auf einen Wert erniedrigt wird, der kleiner als die Spannung am Kondensator (C12) ist, so dass dieser entladen wird.

6. Verfahren nach Anspruch 1, wobei Schwingungspakete verschiedener Dauer empfangen werden, dadurch gekennzeichnet, dass die Dauer des vom Signaldetektor (PC) erzeugten Ausgangssignals (AS) proportional der Dauer des jeweils empfangenen Schwingungspaketes ist, und dass die Endflanke des Ausgangssignals (AS) als Triggersignal für die Erzeugung des Entladeimpulses ($\overline{EP}$) verwendet wird.

7. Verfahren nach Anspruch 6, dadurch gekennzeichnet, dass das vom Signaldetektor (PC) erzeugte Ausgangssignal (AS) über die Zeit integriert wird, wobei das Integral ein Mass für die Stromstärke ist, mit welcher der Kondensator (C12) bei Erscheinen des Entladeimpulses ($\overline{EP}$) während einer festen Zeitdauer entladen wird.

8. Verfahren nach Anspruch 7, dadurch gekennzeichnet,
   - dass das vom Signaldetektor (PC) erzeugte Ausgangssignal (AS) integriert wird, indem ein Integrationskondensator (Ci) während der Dauer des Ausgangssignals (AS) durch eine Konstantstromquelle (Q6) aufgeladen wird,
   - dass die Spannung über dem Integrationskondensator (Ci) an eine spannungsgesteuerte Stromquelle (Q5) angelegt wird, welche einen Strom erzeugt, der über eine Diode (D1') fliesst, wobei an der Kathode einer weiteren Diode (D2') eine Spannung gelegt wird, die grösser ist als die an der Anode der weiteren Diode (D2') liegende Spannung des Kondensators (C12), so dass dieser nicht entladen werden kann,
   - und dass bei Erscheinen des Entladeimpulses ($\overline{EP}$) der von der spannungsgesteuerten Stromquelle erzeugte Strom um einen bestimmten Betrag verändert und der Kondensator (C12) während des Entladeimpulses ($\overline{EP}$) entladen wird.

9. Verfahren nach Anspruch 1, dadurch gekennzeichnet, dass die durch den Entladeimpuls ($\overline{EP}$) vom Kondensator (C12) abzuführende Ladung von einer digitalen Schaltung aufgrund der Signaldauer und dem Erkennen des Signales als Nutzsignal bestimmt wird.

10. Einrichtung zur Durchführung des Verfahrens nach Anspruch 5, mit Eingangsverstärker- und -Filterstufen, die mit einer automatischen Verstärkungsregelung (AGC) und einem Signaldetektor (PC) verbunden sind, wobei der Signaldetektor (PC) zum einen mit einer Impulsformerstufe (PF) und zum anderen mit einer Störunterdrückungsschaltung (NS) in Verbindung steht, und wobei der Eingang der automatischen Verstärkungsregelung (AGC) und der Ausgang der Störunterdrückungsschaltung (NS) an dem genannten Kondensator (C12) angeschlossen sind,
dadurch **gekennzeichnet**,
dass eine Diode (D1) vorgesehen ist, deren Anode an einer Spannungsquelle angeschlossen ist und deren Kathode einerseits mit einer Stromquelle (Q4) und andererseits mit der Kathode einer weiteren Diode (D2) verbunden ist, deren Anode mit dem Kondensator (C12) in Verbindung steht.

11. Einrichtung zur Durchführung des Verfahrens nach Anspruch 8, mit Eingangsverstärker- und -Filterstufen, die mit einer automatischen Verstärkungsregelung (AGC) und einem Signaldetektor (PC) verbunden sind, wobei der Signaldetektor (PC) mit einer Störunterdrückungsschaltung (NS) in Verbindung steht, und wobei der Eingang der automatischen Verstärkungsregelung (AGC) und der Ausgang der Störunterdrückungsschaltung (NS) an dem genannten Kondensator (C12) angeschlossen sind,
dadurch **gekennzeichnet**,
- dass eine Diode (D1') vorgesehen ist, deren Kathode einerseits mit einer spannungsgesteuerten Stromquelle (Q5) und andererseits mit der Kathode einer weiteren Diode (D2') verbunden ist, deren Anode mit dem Kondensator (C12) in Verbindung steht,
- dass die Diode (D1') mit der Anode an einem Ausgang ($\overline{a}$) eines Monoflops (MF) angeschlossen ist,
- dass ein Transistor (T1') vorgesehen ist, in dessen Ausgangskreis ein Integrationskondensator (Ci) angeordnet ist, der über seinen Anschluss am Kollektor des Transistors (T1') mit einer Konstantstromquelle (Q6) und der spannungsgesteuerten Stromquelle (Q5) in Verbindung steht,
- dass die Basis des Transistors (T1') am Ausgang eines zwei Eingänge aufweisenden NOR-Gatters (NOR) angeschlossen ist, dessen einer Eingang mit dem Ausgang (E') eines Komparators (OA3') und einem Einang (e) des Monoflops (MF) verbunden ist,
- und dass der andere Eingang des NOR-Gatters (NOR) mit einem weiteren Ausgang (a) des Monoflops (MF) in Verbindung steht.

12. Einrichtung zur Durchführung des Verfahrens nach Anspruch 1, mit Eingangsverstärker- und -Filterstufen, die mit einer automatischen Verstärkungsregelung (AGC) und einem Signaldetektor (PC) verbunden sind, wobei der Signaldetektor (PC) zum einen mit einer Impulsformerstufe (PF) und zum anderen mit einer Störunterdrückungsschaltung (NS) in Verbindung steht, und wobei der Eingang der automatischen Verstärkungsregelung (AGC) und der Ausgang der Störunterdrückungsschaltung (NS) an dem genannten Kondensator (C12) angeschlossen sind,
dadurch **gekennzeichnet**, dass eine aus einem Widerstand (R11) und einem Feldeffekttransistor (Fet) bestehende Serieschaltung parallel zum Kondensator (C12) geschaltet ist, wobei der Entladeimpuls ($\overline{EP}$) der Steuerelektrode des Feldeffekttransistors (Fet) zugeführt wird.

13. Einrichtung zur Durchführung des Verfahrens nach Anspruch 2, mit Eingangsverstärker- und -Filterstufen, die mit einer automatischen Verstärkungsregelung (AGC) und einem Signaldetektor (PC) verbunden sind, wobei der Signaldetektor (PC) mit einer Störunterdrückungsschaltung (NS) in Verbindung steht, und wobei der Eingang der automatischen Verstärkungsregelung (AGC) und der Ausgang der Störunterdrückungsschaltung (NS) an dem genannten Kondensator (C12) angeschlossen sind,
dadurch **gekennzeichnet**,
- dass zwei Operationsverstärker (OA5, OA6) vorgesehen sind,
- dass der Ausgang des ersten Operationsverstärkers (OA5) über einen ersten Schalter (S1) mit einem Eingang des zweiten Operationsverstärkers (OA6) verbunden ist,
- dass der Ausgang des zweiten Operationsverstärkers (OA6) über einen zweiten Schalter (S2) an einem Eingang des ersten Operationsverstärkers (OA5) angeschlossen ist, der mit einem Anschluss (13) und dem Kondensator (C12) in Verbindung steht,
- und dass ein weiterer Kondensator (Cs) vorgesehen ist, der mit dem einen Eingang des zweiten Operationsverstärkers (OA6) verbunden ist.

Fig. 1

VCC

V1    V2    V3    U1

INP    HP    TP    D

REF              AGC    13    SC

PF    PC    NS    R11    R12    C12

C2

Fet

In

In_RxD
(Fig. 7)

Rx_Control
(Fig. 7)

Fig. 4

U1.1

Q3

D2

C12    D1    Q4

EP

11

Fig. 2

Fig. 3

a.

b.

c.

d.

e.

Fig. 5

Fig. 6

Fig. 7

14

Fig. 8

Input_TxD → [ 210 ] → Out_TxD

BS

S_Bit

[ 212 ] → Rx_Control

R_Bit

BR

In_RxD → [ 211 ] → Output_RxD

# Fig. 9

| ta | ta | ta | ta | ta | ta |

| Bit1 | Bit2 | Bit3 | Bit4 | Bit5 | Bit6 |

t0

t

| tb | tc | tb | tc | tb | tc | tb | tc | tb | tc | tb | tc |

| Bit1 | | Bit2 | | Bit3 | | Bit4 | | Bit5 | | Bit6 | |

# Fig. 10

"1"                    "0"

PBPM

"0"                    "1"

PBBM

| tb | tc | tb | tc |

| td | | td | |

Signalelement          Signalelement

Fig. 11

Fig. 12

Europäisches
Patentamt

# EUROPÄISCHER RECHERCHENBERICHT

Nummer der Anmeldung

EP 94 81 0131

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int.Cl.5) |
|---|---|---|---|
| A | EP-A-0 192 061 (ALCATEL THOMSON FAISCEAUX) <br> * das ganze Dokument * <br> --- | 1 | H03G3/20 |
| A | US-A-4 161 628 (D.D. MCRAE) <br> * das ganze Dokument * <br> --- | 1 | |
| A | PATENT ABSTRACTS OF JAPAN <br> vol. 5, no. 133 (E-71) 25. August 1981 <br> & JP-A-56 069 937 (PIONEER ELECTRONIC CORP) 11. Juni 1981 <br> * Zusammenfassung * <br> ----- | 1 | |
| | | | **RECHERCHIERTE SACHGEBIETE (Int.Cl.5)** <br><br> H03G <br> H04B |

Der vorliegende Recherchenbericht wurde für alle Patentansprüche erstellt

| Recherchenort | Abschlußdatum der Recherche | Prüfer |
|---|---|---|
| DEN HAAG | 9. Juni 1994 | Deconinck, E |